# EUROPEAN PATENT APPLICATION

(11) **EP 4 770 345 A1**
(43) Date of publication of application: **01.07.2026**
(21) Application number: 25177257.0
(22) Date of filing: 19.05.2025
(51) Int. Cl.: H10F 77/20, H10F 71/00

(54) **SOLAR CELL, METHOD FOR PREPARING SAME, AND PHOTOVOLTAIC MODULE**

(30) Priority: 30.12.2024 CN 202411970862
(71) Applicant: CSI Cells (YangZhou) Co., Ltd., Yangzhou, Jiangsu 225000 (CN)
(72) Inventor: YE, Xiaoya, Jiangsu, 215000 (CN); CHEN, Haiyan, Jiangsu, 215000 (CN); DENG, Weiwei, Jiangsu, 215000 (CN)
(74) Representative: Epping - Hermann - Fischer

(57) **Abstract**

Provided are a solar cell, a method for preparing the same, and a photovoltaic module. The solar cell includes a silicon substrate, a tunneling passivation contact structure, and a second electrode. The silicon substrate includes a first surface and a second surface arranged opposite to the first surface. The second surface includes first regions and second regions that are alternately arranged. A tunneling passivation is disposed on the second surface. A projection of the tunneling passivation contact structure on the second surface of the silicon substrate is located within the first region. The tunneling passivation contact structure includes a tunneling layer in direct contact with the silicon substrate, a second doped layer disposed on the tunneling layer, and a blocking layer and a third doped layer that are sequentially disposed on the second doped layer. The second doped layer, the third doped layer and the silicon substrate contain impurities of same conductive type. The second electrode is disposed in the second region and in contact with the third doped layer. The solar cell of the present disclosure can reduce parasitic absorption on the back surface of the cell and increase a current, without affecting contact performance between the electrode and the doped layer on the back surface, thereby improving a cell efficiency and bifaciality and enhancing a process window.

## Description

### FIELD

The present disclosure belongs to the technical field of photovoltaic cell, and more particularly, to a solar cell, a method for preparing the same, and a photovoltaic module.

### BACKGROUND

A Tunnel Oxide Passivated Contact (TOPCon) cell is a solar cell structure. An ultrathin tunnel oxide layer and a doped polysilicon layer are sequentially prepared on a back surface of a silicon substrate.

TOPCon cells exhibit excellent passivation and conductivity properties of n+ polarity and p+ polarity, and are compatible with conventional industrial production, indicating broad prospects for development.

### SUMMARY

An objective of the present disclosure is to provide a solar cell, a method for preparing the same, and a photovoltaic module, which can ensure passivation performance of a back surface into and reduce parasitic absorption of the back surface, improving a cell efficiency.

To achieve the above objective, a technical solution according to an embodiment of the present disclosure is as follows.

A solar cell includes a silicon substrate, a tunneling passivation contact structure, and a second electrode. The silicon substrate includes a first surface and a second surface arranged opposite to the first surface. The second surface includes first regions and second regions that are alternately arranged. A tunneling passivation is disposed on the second surface. A projection of the tunneling passivation contact structure on the second surface of the silicon substrate is located within the first region. The tunneling passivation contact structure includes a tunneling layer in direct contact with the silicon substrate, a second doped layer disposed on the tunneling layer, and a blocking layer and a third doped layer that are sequentially disposed on the second doped layer. The second doped layer, the third doped layer and the silicon substrate contain impurities of same conductive type. The second electrode is disposed in the second region and in contact with the third doped layer.

In an embodiment, a thickness of the third doped layer is greater than or equal to a thickness of the second doped layer.

In an embodiment, a total thickness of the second doped layer and the third doped layer ranges from 50 nm to 150 nm or from 60 nm to 100 nm.

In an embodiment, a thickness of the second doped layer ranges from 1 nm to 100 nm, and a thickness of the third doped layer ranges from 1 nm to 150 nm.

In an embodiment, the thickness of the second doped layer ranges from 1 nm to 50 nm, and the thickness of the third doped layer ranges from 50 nm to 100 nm.

In an embodiment, the solar cell according further includes a second passivation layer.

In an embodiment, the second passivation layer is in contact with the second surface of the silicon substrate in the second region, and the second passivation layer covers the third doped layer in the first region.

In an embodiment, the second passivation layer is an aluminum oxide passivation layer and has a thickness ranging from 2 nm to 7 nm or from 3 nm to 6 nm.

In an embodiment, the solar cell according further includes a second anti-reflection layer disposed on the second passivation layer.

In an embodiment, the second anti-reflection layer is a layered film formed by one or more of a silicon nitride layer, a silicon oxynitride layer, and a silicon oxide layer, the second anti-reflection layer having a thickness ranging from 60 nm to 130 nm.

In an embodiment, the silicon substrate is an N-type silicon substrate, and each of the second doped layer and the third doped layer is an N-type doped polysilicon layer.

In an embodiment, a surface doping concentration of the third doped layer is greater than or equal to a surface doping concentration of the second doped layer.

In an embodiment, a surface doping concentration of the second doped layer ranges from 3E20 cm⁻³ to 3E21 cm⁻³ or from 5E20 cm⁻³ to 2E21 cm⁻³.

In an embodiment, the surface doping concentration of the third doped layer ranges from 3E20 cm⁻³ to 3E21 cm⁻³ or from 5E20 cm⁻³ to 2E21 cm⁻³.

In an embodiment, the tunneling layer is one of a silicon oxide layer and a silicon oxynitride layer, or a combination thereof.

In an embodiment, a thickness of the tunneling layer ranges from 0.5 nm to 3 nm or from 1.5 nm to 2.5 nm.

In an embodiment, the blocking layer is one of a silicon oxide layer and a silicon carbide layer, or a combination thereof.

In an embodiment, a thickness of the blocking layer ranges from 0.5 nm to 3 nm or from 1.5 nm to 2 nm.

In an embodiment, the solar cell according further includes a first doped layer and a first electrode formed on the first surface of the silicon substrate.

In an embodiment, the first doped layer containing impurities of a conductive type opposite to that of the silicon substrate, and the first electrode is in contact with the first doped layer.

In an embodiment, the first doped layer is a P-type doped layer.

In an embodiment, a surface doping concentration of the first doped layer ranges from 3E18 cm⁻³ to 3E19 cm⁻³.

In an embodiment, the solar cell according further includes a first passivation layer and a first anti-reflection layer that are disposed on the first doped layer.

In an embodiment, the first passivation layer is an aluminum oxide passivation layer and has a thickness ranging from 2 nm to 7 nm or from 3 nm to 6 nm; and the first anti-reflection layer is a layered film formed by one or more of a silicon nitride layer, a silicon oxynitride layer, and a silicon oxide layer and has a thickness ranging from 60 nm to 130 nm.

In an embodiment, a plurality of first regions are arranged in parallel, and a plurality of second regions are arranged in parallel, the plurality of first regions and plurality of second regions being alternately arranged; and the second electrode includes a plurality of grid lines arranged in parallel, the plurality of grid lines corresponding to the plurality of first regions in one-to-one correspondence, and a width of each of the plurality of first regions being greater than or equal to a width of each of the plurality of grid lines.

In an embodiment, the width of each of the plurality of first regions ranges from 50 µm to 150 µm, and the width of each of the plurality of grid lines ranges from 15 µm to 100 µm.

In an embodiment, a pyramidal texture structure is formed on the first surface of the silicon substrate; and/or the second surface of the silicon substrate is a polished surface.

A technical solution according to another embodiment of the present disclosure is as follows.

A method for preparing a solar cell includes: providing a silicon substrate comprising a first surface and a second surface arranged opposite to the first surface, wherein the second surface includes first regions and second regions that are alternately arranged; preparing a tunneling passivation contact structure on the second surface, wherein the tunneling passivation contact structure comprises a tunneling layer, a second doped layer, a blocking layer, and a third doped layer that are sequentially disposed on each other; removing the tunneling passivation contact structure in the second region, to retain the tunneling passivation contact structure in the first region; and preparing a second electrode at the tunneling passivation contact structure in the first region, the second electrode being in contact with the third doped layer.

In an embodiment, the method further includes, prior to said removing the tunneling passivation contact structure in the second region: treating the third doped layer in the first region using a laser processing, to form an oxide layer on a surface of the third doped layer in the first region.

In an embodiment, the laser processing is performed in an oxygen-containing atmosphere, with a volume concentration of oxygen ranging from 20% to 80%.

In an embodiment, a laser power during the laser processing ranges from 1 W to 100 W or from 30 W to 60 W.

In an embodiment, a laser frequency during the laser processing ranges from 1 kHz to 1,000 kHz or from 300 kHz to 600 kHz.

In an embodiment, a laser scanning speed during the laser processing ranges from 10,000 mm/s to 100,000 mm/s or from 30,000 mm/s to 60,000 mm/s.

In an embodiment, the number of times of laser processing operations during the laser processing ranges from 1 to 100 or from 1 to 10.

In an embodiment, the removing the tunneling passivation contact structure in the second region includes: removing, by using the oxide layer as a mask, the second doped layer, the blocking layer, and the third doped layer in the second region using an alkali solution, and removing the tunneling layer in the second region and the oxide layer in the first region using an acid solution.

In an embodiment, the preparing the tunneling passivation contact structure on the second surface includes: sequentially depositing the tunneling layer, a first doped amorphous silicon layer, the blocking layer, and a second doped amorphous silicon layer on the second surface of the silicon substrate; and performing annealing on the silicon substrate deposited with the tunneling layer, the first doped amorphous silicon layer, the blocking layer, and the second doped amorphous silicon layer at a temperature ranging from 880°C to 980°C to convert doped amorphous silicon layers into doped polysilicon layers.

In an embodiment, the method further includes: preparing a light-trapping structure on each of the first surface and the second surface of the silicon substrate through a texturing process; and polishing the second surface of the silicon substrate prior to said preparing the tunneling passivation contact structure.

In an embodiment, the method further includes: preparing a first doped layer on the first surface, the first doped layer containing impurities of a conductive type opposite to that of the silicon substrate; and preparing a first electrode on the first surface, the first electrode being in contact with the first doped layer.

In an embodiment, the method further includes: preparing a first passivation layer and a first anti-reflection layer on the first surface of the silicon substrate; and preparing a second passivation layer and a second anti-reflection layer on the second surface of the silicon substrate.

A technical solution according to yet another embodiment of the present disclosure is as follows.

A photovoltaic module includes the solar cell as described above.

Compared with the related art, the present disclosure can provide the following advantages.

In the solar cell of the present disclosure, only the metallic region of the back surface is laminated with a tunneling passivation contact structure, and a non-metallic region do not have such a structure. In this way, parasitic absorption on the back surface of the cell can be reduced and a current can be increased, without affecting contact performance between the electrode and the doped layer on the back surface, which can improve a cell efficiency and bifaciality and enhancing a process window.

The tunneling passivation contact structure in the metallic region of the back surface includes two doped layers and one blocking layer. The blocking layers have a certain capacity of blocking the electrode paste to penetrate through the back surface, which can further reduce a total thickness of the doped layers on the back surface, thereby enhancing an open-circuit voltage of the cell and improving a cell efficiency.

The second passivation layer in the non-metallic region of the back surface can ensure the passivation performance of the back surface of the cell. Additionally, the second passivation layer also has a certain effect of blocking the electrode paste to penetrate through the back surface, allowing the total thickness of the doped layers in the metallic region to be further reduced. In this way, a short-circuit current density of the cell can be increased without affecting performance of metallized contact, thereby improving the cell efficiency and the bifaciality.

### BRIEF DESCRIPTION OF THE DRAWINGS

In order to clearly explain technical solutions of embodiments of the present disclosure or in the related art, drawings used in description of the embodiments or the related art are briefly described below. The drawings as described below are merely some embodiments of the present disclosure. Based on these drawings, other drawings can be obtained by those skilled in the art without paying creative efforts.
FIG. 1 is a schematic structural view of a solar cell in Example 1 of the present disclosure.
FIG. 2 is a schematic partial structural view of part A in FIG. 1.
FIG. 3 is a schematic plan view of a second surface of a silicon substrate in Example 1 of the present disclosure.
FIG. 4 is a schematic plan view of a second surface and a second electrode in Example 1 of the present disclosure.
FIG. 5a to FIG. 5j are each a flowchart of a preparation process of a solar cell in Example 1 of the present disclosure.
FIG. 6 is a schematic view of a laser scanning pattern in a laser processing in Example 1 of the present disclosure.
FIG. 7a to FIG. 7c are schematic views for illustrating a process for preparing a first doped layer on a first surface of a silicon substrate in Example 2 of the present disclosure.
FIG. 8a and FIG. 8b are schematic views for illustrating a process for preparing a mask at a first region in Example 3 of the present disclosure.

Description of main reference numerals of the accompanying drawings:
10: substrate; 11: first doped layer; 11': boron-doped amorphous silicon layer; 21: first passivation layer; 31: first anti-reflection layer; 12: tunneling layer; 13: second doped layer; 14: blocking layer; 15: third doped layer; 151: oxide layer; 152: oxide layer; 22: second passivation layer; 32: second anti-reflection layer; 41: first electrode; 42: second electrode; 421: fine grid line; S1: first surface; S2: second surface; S21: first region; S22: second region; 101: first sub-region; 102: second sub-region.

### DETAILED DESCRIPTION

In order to enable those skilled in the art to better understand technical solutions in the present disclosure, technical solutions according to embodiments of the present disclosure are described clearly and completely below in combination with accompanying drawings of the embodiments of the present disclosure. The embodiments described below are only a part of the embodiments of the present disclosure, rather than all embodiments of the present disclosure. Based on the embodiments of the present disclosure, all other embodiments obtained by those skilled in the art without paying creative efforts shall fall within the protection scope of the present disclosure.

In the present disclosure, unless expressly stated and defined otherwise, the first feature "on" or "under" the second feature may mean that the first feature is in direct contact with the second feature, or that the first and second features are in indirect contact through an intermediate. Moreover, the first feature "above" the second feature may mean that the first feature is directly above or obliquely above the second feature, or simply mean that the level of the first feature is higher than that of the second feature. The first feature "below" the second feature may mean that the first feature is directly below or obliquely below the second feature, or simply mean that the level of the first feature is smaller than that of the second feature.

The present disclosure provides a solar cell. The solar cell includes a silicon substrate, a tunneling passivation contact structure, and a second electrode. The silicon substrate includes a first surface and a second surface arranged opposite to the first surface. The second surface includes first regions and second regions that are alternately arranged. The tunneling passivation contact structure and the second electrode are disposed in a part region of the second surface. A projection of the tunneling passivation contact structure on the second surface of the silicon substrate is located within the first region. The tunneling passivation contact structure includes a tunneling layer in direct contact with the silicon substrate, a second doped layer disposed on the tunneling layer, and a blocking layer and a third doped layer sequentially disposed on the second doped layer. The second doped layer, the third doped layer and the silicon substrate contain impurities of same conductive type. The second electrode is in contact with the third doped layer.

The present disclosure further provides a method for preparing a solar cell. The method includes: providing a silicon substrate including a first surface and a second surface arranged opposite to the first surface, the second surface including first regions and second regions that are alternately arranged; preparing a tunneling passivation contact structure on the second surface, the tunneling passivation contact structure including a tunneling layer, a second doped layer, a blocking layer, and a third doped layer that are sequentially disposed on each other; removing the tunneling passivation contact structure in the second region, and retaining the tunneling passivation contact structure in the first region; and preparing a second electrode in the first region, the second electrode being in contact with the third doped layer.

The present disclosure further provides a photovoltaic module. The photovoltaic module includes the solar cell as described above.

In the solar cell of the present disclosure, only the metallic region of the back surface is laminated with a tunneling passivation contact structure, and a non-metallic region do not have such a structure. In this way, parasitic absorption on the back surface of the cell can be reduced and a current can be increased, without affecting contact performance between the electrode and the doped layer on the back surface, which can improve a cell efficiency and bifaciality and enhance a process window.

The present disclosure is further described below in combination with specific examples.

### Example 1

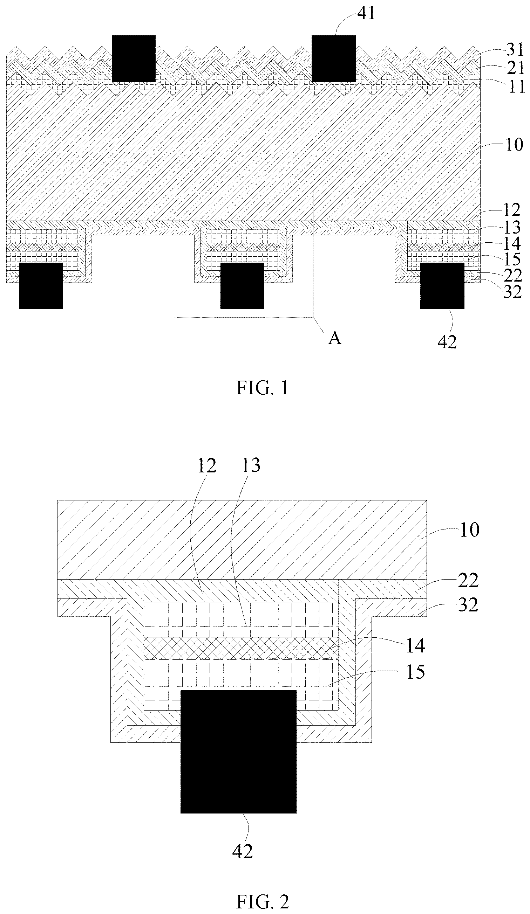

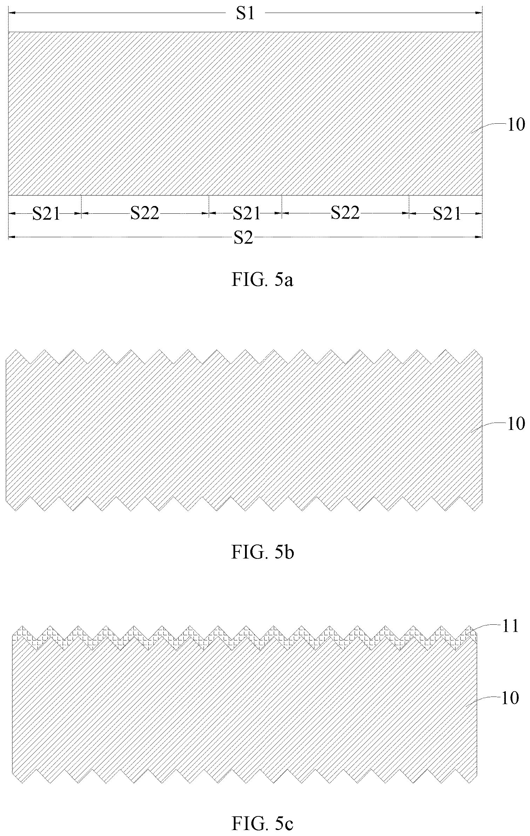

FIG. 1 is a schematic structural view of a solar cell in the present example. As illustrated in FIG. 1, the solar cell is a TOPCon cell and includes a silicon substrate 10. In combination with FIG. 5a, the silicon substrate 10 includes a first surface S1 and a second surface S2 opposite to the first surface S1. The second surface S2 includes first regions S21 and second regions S22. The first surface S1 is a front surface (i.e., a primary light-receiving surface) of the silicon substrate 10, and the second surface S2 is a back surface (i.e., a secondary light-receiving surface) of the silicon substrate 10. The first region S21 is a metallic region of the back surface, and the second region S22 is a non-metallic region of the back surface.

In the present example, the silicon substrate 10 is an N-type silicon substrate having a resistivity ranging from 0.3 Ω·cm to 7 Ω·cm, preferably from 0.5 Ω·cm to 3.5 Ω·cm.

Further, a light-trapping structure is formed on the first surface S1 of the silicon substrate 10. For example, a pyramidal texture structure may be formed on the first surface S1 of the silicon substrate 10 through alkaline texturing. A size of the base of the pyramid ranges from 0.5 µm to 3 µm. The second surface S2 of the silicon substrate 10 is a polished surface, which can be either a surface resulting from performing chemical polishing on the light-trapping structure or a surface resulting from directly chemically polishing a back surface of the original silicon substrate. For instance, in the present example, the pyramidal texture structure is formed on the second surface S2 of the silicon substrate 10 by performing the alkaline texturing, and the size of the pyramid ranges from 0.5 µm to 3 µm. Thereafter, alkaline polishing is performed on the back surface to obtain the polished surface. Compared with a back surface of a conventional silicon substrate, the polished surface is formed with a plurality of pyramid bases, which are the bases left after polishing the pyramidal texture structure.

In the present example, a first doped layer 11 (i.e., an emitter) is formed on the first surface S1 of the silicon substrate 10 through a diffusion process or a Plasma Enhance Chemical Vapor Deposition (PECVD) process, forming a PN junction that generates minority carrier-hole pairs under illumination. For example, the first doped layer 11 in the present example is a P-type doped layer (i.e., a P+ emitter), which is formed under the first surface S1 of the silicon substrate 10 (i.e., within the silicon substrate) through a boron doping process, with a surface doping concentration ranging from 3E18 cm⁻³ to 3E19 cm⁻³. A sheet resistance ranges from 40 Ω/sq to 300 Q/sq, preferably from 150 Ω/sq to 280 Q/sq.

With reference to FIG. 1 and in conjunction with FIG. 2, in the present example, the tunneling passivation contact structure is only provided in the first region S21 of the second surface S2 of the silicon substrate 10, and the second region S22 is provided without the tunneling passivation contact structure.

Specifically, the tunneling passivation contact structure in the first region S21 includes a tunneling layer 12, a second doped layer 13, a blocking layer 14, and a third doped layer 15 that are sequentially disposed on each other. A projection of the tunneling passivation contact structure on the second surface S2 of the silicon substrate 10 is located within the first region S21. The tunneling layer 12 is in direct contact with the second surface S2 of the silicon substrate 10 in the first region S21, which can provide a satisfactory interface passivation effect in the first region S21. The second doped layer 13 and the third doped layer 15 can provide a field passivation effect and improving contact and reducing a resistance. No tunneling layer 12 and doped layers are formed in the second region S22, thereby reducing a thickness in the second region S22. In this way, parasitic absorption of light on the back surface can be reduced, thereby enhancing a short-circuit current density of the cell and significantly improving the cell efficiency and the bifaciality.

The tunneling layer 12 is a silicon oxide (SiO_{X}) layer, a silicon oxynitride (SiO_{X}N_{Y}) layer, or a combination thereof. Preferably, the tunneling layer 12 is a silicon oxide layer. The tunneling layer 12 has a thickness ranging from 0.5 nm to 3 nm, preferably from 1.5 nm to 2.5 nm. The blocking layer 14 is a silicon oxide (SiO_{X}) layer, a silicon carbide (SiC) layer, or a combination thereof. Preferably, the blocking layer 14 is a silicon oxide (SiO_{X}) layer. The blocking layer 14 has a thickness ranging from 0.5 nm to 3 nm, preferably from 1.5 nm to 2 nm.

The second doped layer 13, the third doped layer 15 and the silicon substrate contain impurities of same conductive type. Further, a surface doping concentration of the third doped layer 15 is greater than or equal to that of the second doped layer 13, and a thickness of the third doped layer 15 is greater than or equal to that of the second doped layer 13. A total thickness of the second doped layer 13 and the third doped layer 15 ranges from 50 nm to 150 nm, preferably from 60 nm to 100 nm. Specifically, in the present example, the second doped layer 13 is a phosphorus-doped polysilicon layer, having a surface doping concentration ranging from 3E20 cm⁻³ to 3E21 cm⁻³, preferably from 5E20 cm⁻³ to 2E21 cm⁻³, and a thickness ranging from 1 nm to 100 nm, preferably from 1 nm to 50 nm; and the third doped layer 15 is a phosphorus-doped polysilicon layer, having a surface doping concentration ranging from 3E20 cm⁻³ to 3E21 cm⁻³, preferably from 5E20 cm⁻³ to 2E21 cm⁻³, and a thickness ranging from 1 nm to 150 nm, preferably from 50 nm to 100 nm.

In the present disclosure, the tunneling passivation contact structure including the tunneling layer, the second doped layer, the blocking layer, and the third doped layer is provided only in the first region S21 (the metallic region of the back surface) of the back surface of the silicon substrate, and the tunneling passivation contact structure is completely removed in the second region S22 (the non-metallic region of the back surface). As two doped layers are laminated in the first region S21, the underlying tunneling layer 21 can be protected from being destroyed by electrode paste penetrating the doped layer during sintering, thereby ensuring the field passivation effect. In addition, a thickness of a back surface in the second region S22 is significantly reduced, which can reduce the parasitic absorption of the light on the back surface, thereby enhancing the short-circuit current density of the cell and improving the cell efficiency.

Additionally, by introducing the blocking layer 14 between the second doped layer 13 and the third doped layer 15, the blocking layer 14 has a certain capacity of blocking the electrode paste to penetrate through the back surface. Thus, the total thickness of the second doped layer 13 and the third doped layer 15 can be further reduced. For instance, in the present example, the total thickness of the second doped layer 13 and the third doped layer 15 can be reduced to a value ranging from 60 nm to 100 nm. In this way, an open-circuit voltage (Voc) of the cell is further enhanced, improving the cell efficiency.

In the present disclosure, a thickness of the blocking layer 14 has significant impacts on both a cell preparation process and cell performance. If the blocking layer 14 is excessively thin, it cannot be ensured that the blocking layer 14 can block the electrode paste to penetrate through the back surface. If the blocking layer 14 is excessively thick, the blocking layer 14 has an intensified capability of blocking against inward diffusion of phosphorus, thereby affecting ohmic contact. Therefore, in the present example, the thickness of the blocking layer 14 ranges from 0.5 nm to 3 nm, preferably, from 1.5 nm to 2 nm.

Preferably, in the present example, a first passivation layer 21 and a first anti-reflection layer 31 are sequentially disposed on the first surface S1 of the silicon substrate 10, and a second passivation layer 22 and a second anti-reflection layer 32 are sequentially disposed on the second surface S2 of the silicon substrate 10. The second passivation layer 22 and the second anti-reflection layer 32 cover the second doped layer 13 and extend into the second region S22. The second passivation layer 22 is in direct contact with the silicon substrate 10 in the second region S22. The first passivation layer 21 can provide satisfactory field and chemical passivation effects. The second passivation layer 22 can provide a chemical passivation effect. The first anti-reflection layer 31 can reduce reflectivity and increase light utilization.

For example, each of the first passivation layer 21 and the second passivation layer 22 is an aluminum oxide passivation layer having a thickness ranging from 2 nm to 7 nm, preferably from 3 nm to 6 nm. Each of the first anti-reflection layer 31 and the second anti-reflection layer 32 may be a layered film formed by one or more of a silicon nitride layer, a silicon oxynitride layer, and a silicon oxide layer. The first anti-reflection layer 31 and the second anti-reflection layer 32 have each a thickness ranging from 60 nm to 130 nm. Preferably, each of the first anti-reflection layer 31 and the second anti-reflection layer 32 is a silicon nitride layer. Silicon nitride is chemically inactive and has strong acid and alkali corrosion resistance, which can lower environmental sensitivity of the cell.

Moreover, in the present example, the first electrode 41 is located on the first surface S1 of the silicon substrate 10 and is in contact with the first doped layer 11, and the second electrode 42 is located on the second surface S2 of the silicon substrate 10. Specifically, the second electrode 42 is located in the first region S21 of the second surface S2 and is in contact with the second doped layer 13.

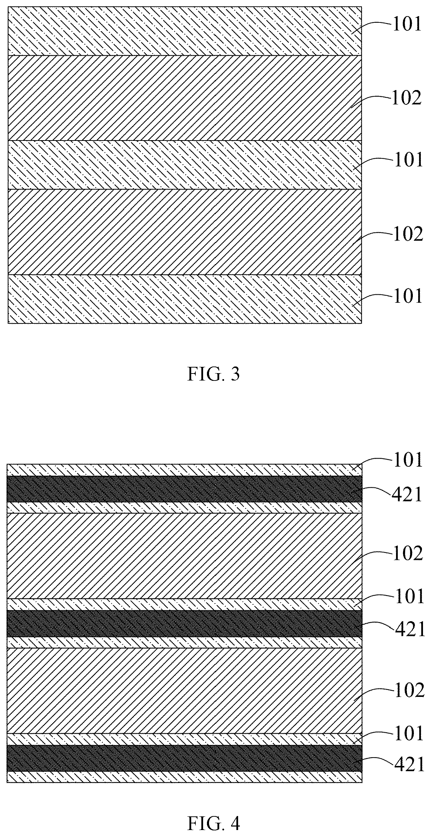

As illustrated in FIG. 3, in the present example, the first region S21 includes a plurality of first sub-regions 101 distributed in parallel and at equal intervals, and the second region S22 includes a plurality of second sub-regions 102 distributed in parallel and at equal intervals. The first sub-regions 101 and the second sub-regions 102 are alternately arranged. A width of the first sub-region 101 is smaller than a width of the second sub-region 102. For example, a ratio of the width of the first sub-region 101 to the width of the second sub-region 102 may be 1: (5 to 20). Preferably, the first region S21 occupies about 10% of an area of the entire second surface S2.

As illustrated in FIG. 4, the second electrode 42 is a grid line electrode at least including a plurality of fine grid lines 421 arranged in parallel. The width of the first sub-region 101 is greater than or equal to a width of the fine grid line 421. Optionally, the second electrode 42 may further include a plurality of main grid lines (not illustrated) perpendicular to the plurality of fine grid lines 421.

In the present example, a 210 TOPCon cell is adopted. A size of the 210 TOPCon cell is 203.396 mm ± 15 mm. The 210 TOPCon cell includes 230 fine grid lines 421 each having a width ranging from 15 µm to 100 µm. A spacing between adjacent fine grid lines is 0.907 mm ± 0.015 mm. A spacing between adjacent first sub-regions 101 is equal to the spacing between the adjacent fine grid lines. Each first sub-region 101 is provided with one fine grid line 421 thereon. The width of the first sub-region 101 is greater than that of the fine grid line 421. The width of the first sub-region ranges from 50 µm to 150 µm. For example, the width of the fine grid line is 40 µm, and the width of the first sub-region is 80 µm.

In the present example, a method for preparing the solar cell specifically includes the following steps.

### 1. Double-sided texturing

As illustrated in FIG. 5a, a silicon substrate 10 is provided, which includes a first surface S1 and a second surface S2 arranged opposite to the first surface S1. The second surface S2 includes first regions S21 and second regions S22. The first surface S1 is a front surface (i.e., a light-receiving surface) of the silicon substrate 10, and the second surface S2 is a back surface (i.e., a non-light-receiving surface) of the silicon substrate 10. The first region S21 is a metallic region of the back surface, and the second region S22 is a non-metallic region of the back surface.

In the present example, the silicon substrate 10 is an N-type silicon substrate having a resistivity ranging from 0.3 Ω·cm to 7 Ω·cm, preferably from 0.5 Ω·cm to 3.5 Ω·cm.

As illustrated in FIG. 5b, a pyramidal texture structure is formed on each of the first surface S1 and the second surface S2 of the silicon substrate 10 through alkaline texturing process. A size of the pyramid ranges from 0.5 µm to 3 µm.

### 2. Boron diffusion

As illustrated in FIG. 5c, a first doped layer 11 (i.e., a P+ emitter) of P-type doping is formed on the first surface S1 of the silicon substrate 10 through a boron diffusion process. Specifically, diffusion is carried out in a high-temperature furnace tube using a boron source (such as BCl₃ or BBr₃) via a deposition and drive-in method, to form an outer layer of silicon oxide. After the diffusion, a surface doping concentration of the first doped layer ranges from 3E18 cm⁻³ to 3E19cm⁻³, and a sheet resistance of the first doped layer ranges from 40 Ω/sq to 300 Q/sq, preferably from 150 Ω/sq to 250 Q/sq. In the boron diffusion process, BSG (not illustrated) is formed on the second surface S2 of the silicon substrate.

In the present example, the outer silicon layer on the first surface S1 of the silicon substrate 10 is converted into a boron-diffused layer. A total thickness of the silicon substrate 10 and the first doped layer 11 after the boron diffusion in FIG. 5c is equal to a thickness of the silicon substrate 10 before the boron diffusion in FIG. 5b.

### 3. Back surface polishing

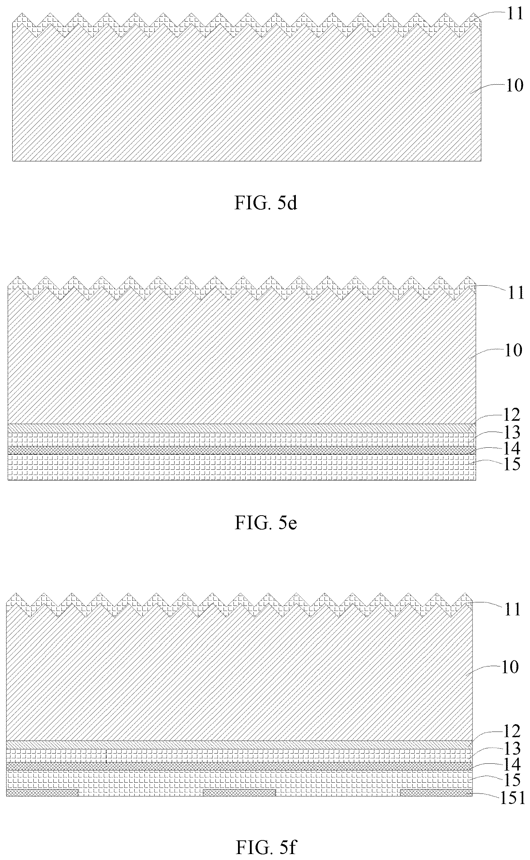

As illustrated in FIG. 5d, the silicon substrate obtained after the boron diffusion passes through a single-sided chain device where a hydrofluoric acid solution is used to remove silicon oxide from the back surface. Then, alkaline polishing is performed on the back surface to remove edge junctions and back surface winding plating (BSG), followed by cleaning.

### 4. Preparation of a tunnel passivation structure on the back surface

As illustrated in FIG. 5e, a tunneling layer 12, a second doped layer 13, a blocking layer 14, and a third doped layer 15 sequentially prepared and disposed on the second surface S2.

For example, in the present example, deposition is performed using the PECVD process. A silicon oxide tunneling layer is first deposited on the back surface, with a thickness ranging from 0.5 nm to 3 nm, preferably from 1.5 nm to 2.5 nm. Then, a phosphorus-doped amorphous silicon layer (the first doped layer) is deposited, with a thickness ranging from 1 nm to 100 nm, preferably from 1 nm to 50 nm. Subsequently, a silicon oxide blocking layer is deposited, with a thickness ranging from 0.5 nm to 3 nm, preferably from 1.5 nm to 2.5 nm. Finally, another phosphorus-doped amorphous silicon layer (the second doped layer) is deposited, with a thickness ranging from 1 nm to 150 nm, preferably from 50 nm to 100 nm.

For example, thicknesses of the silicon oxide tunneling layer, the first phosphorus-doped amorphous silicon layer, the silicon oxide blocking layer, and the second phosphorus-doped amorphous silicon layer are 1.8 nm, 50 nm, 1.5 nm, and 70 nm, respectively. A total thickness of the doped layers at the back surface is 120 nm.

### 5. Laser oxidation

As illustrated in FIG. 5f, the third doped layer 15 in the first region S21 is treated by a laser processing to form an oxide layer 151 on a surface of the third doped layer 15 in the first region S21.

A silicon oxide (SiO_{X}) layer is formed on a surface of a phosphorus-doped polysilicon layer in the first region S21 by utilizing the instantaneous high temperature of laser in the laser processing. The silicon oxide layer serves as a mask for subsequent processes.

Specifically, the laser processing is performed in an oxygen-containing atmosphere with a volume concentration of the oxygen from 20% to 80%. In the laser processing, laser power ranges from 1 W to 100 W, preferably from 30 W to 60 W; a laser frequency ranges from 1 kHz to 1,000 kHz, preferably from 300 kHz to 600 kHz; and a laser scanning speed ranges from 10,000 mm/s to 100,000 mm/s, preferably from 30,000 mm/s to 60,000 mm/s. The number of times of laser processing operations in the laser processing ranges from 1 to 100 times, preferably from 1 to 10 times. The formed oxide layer 151 has a thickness of 0.01 nm to 10 nm.

In a specific example of the laser processing, the volume concentration of oxygen is 50%, the laser power is 30 W, the laser frequency is 500 kHz, the laser scanning speed is 50,000 mm/s, The laser processing is performed twice, and the thickness of the silicon oxide layer formed by oxidizing a surface of the phosphorus-doped amorphous silicon layer ranges from 0.01 nm to 10 nm.

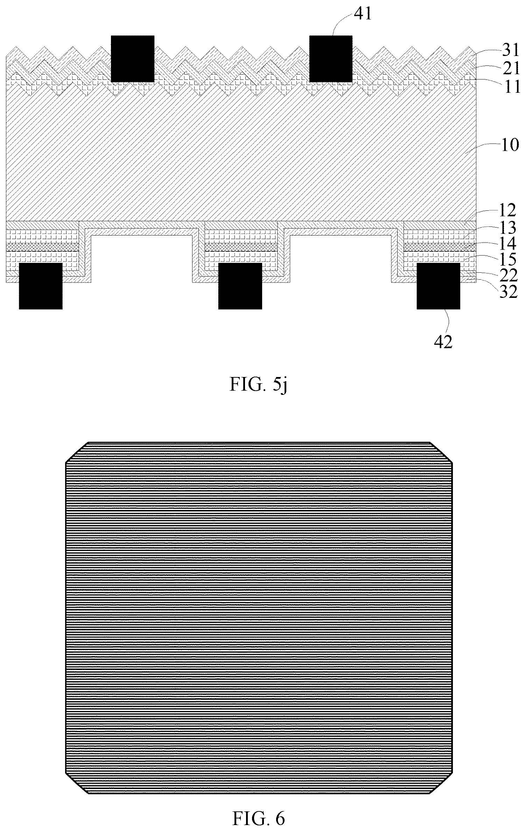

FIG. 6 illustrates a laser scanning pattern in the laser processing in the present example. In FIG. 6, the black lines correspond to the laser scanned regions, i.e., the first regions S21 (i.e., the metallic regions), and the blank portions represent the second regions S22 (i.e., the non-metallic regions). After the laser processing, a structure in the first region S21 is composed of the tunneling layer/the phosphorus-doped polysilicon layer/the blocking layer/the phosphorus-doped polysilicon layer/the silicon oxide layer, whereas a structure on the second region S22 is composed of the tunneling layer/the phosphorus-doped polysilicon layer/the blocking layer/the phosphorus-doped polysilicon layer.

It should be understood that the laser scanning pattern in the present disclosure can be designed based on different electrode structures, to form a patterned silicon oxide mask on a surface of the amorphous silicon layer below the laser scanning region (i.e., the metallic region of the back surface). Laser scanning patterns for other electrode structures will not be exhaustively exemplified here.

### 6. Annealing activation

An annealing treatment is carried out in a high-temperature annealing furnace at a temperature ranging from 880°C to 980°C, preferably from 900°C to 950°C. After the annealing, the phosphorus-doped amorphous silicon layer is converted into the phosphorus-doped polysilicon layer. A phosphorus activation is achieved through the annealing. The tunneling passivation contact structure is formed on the back surface. The surface doping concentration of each of the second doped layer 13 and the third doped layer 15 after the annealing ranges from 3E20 cm⁻³ to 3E21 cm⁻³, preferably from 5E20 cm⁻³ to 2E21 cm⁻³.

For instance, in the present example, the annealing is performed at a temperature of 910°C. After the annealing, the surface doping concentration of the second doped layer 13 is 8E20 cm⁻³, and the surface doping concentration of the third doped layer 15 is 1E21 cm⁻³.

### 7. Removal of winding plating and chemical etching

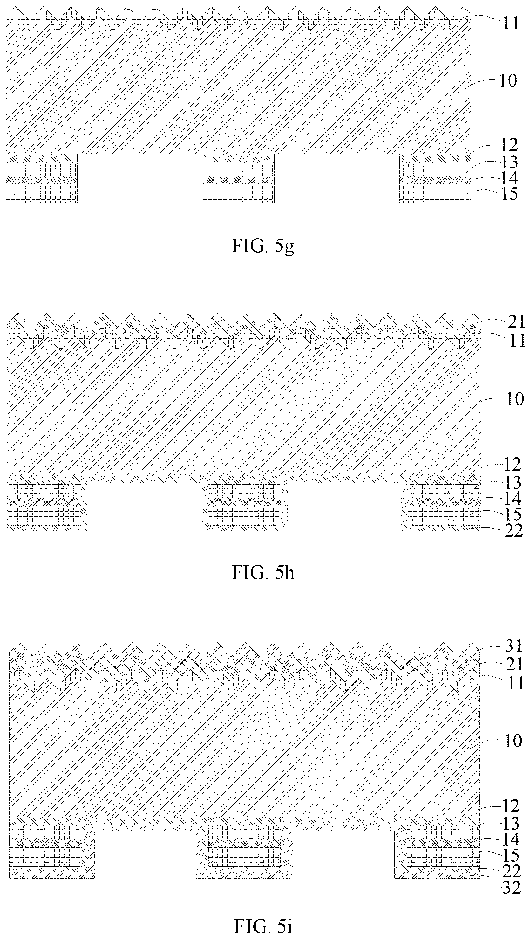

As illustrated in FIG. 5g, the tunneling passivation contact structure in the second region S22 and the oxide layer 151 in the first region S21 are removed by a chemical etching process, and the tunneling passivation contact structure in the first region S21 is retained.

This step specifically includes the following actions.

Alkaline etching: in an alkaline washing tank, by using an alkali solution having a mass fraction ranging from 3% to 15%, the second doped layer 13, the blocking layer 14, and the third doped layer 15 in the second region S22 are removed, while the front surface and edge winding plating is removed.

Acid washing: in an acid washing tank, by using an acid solution having a mass fraction ranging from 5% to 20%, the tunneling layer 12 in the second region S22 and the oxide layer 151 in the first region are removed, while PSG on the front surface is removed.

Finally, RCA cleaning is performed, which is known in the related art and thus is not described in detail herein.

Preferably, in the present example, the acid solution is prepared by mixing an industrial-grade hydrofluoric acid solution (with a mass fraction 40%) with water in a predetermined ratio, and the alkali solution is prepared by mixing an industrial-grade sodium hydroxide solution (with a mass fraction 32%) with water in a predetermined ratio.

In the related art, a front-surface chain process (acid washing) is usually required to be performed before the step of alkaline etching, which involves passing through a chain-type hydrofluoric acid tank to remove the silicon oxide mask from the edge winding plating on one surface. However, since the silicon oxide mask in the present disclosure is not prepared via the PECVD process, no edge winding plating is formed, and thus the front-surface chain process is not required.

During the alkaline etching, the phosphorus-doped amorphous silicon layer in the second region S22 is corroded, which can reduce the parasitic absorption on the back surface of the cell and increases a current. The locking layer 14, due to its thinness and porous surface, can also be removed during the alkaline etching.

Specifically, an additive is usually added to an alkaline etching solution to protect the silicon oxide mask in the first region S21, for example, EST-10 additive from Jiaxing Shining Photovoltaic Material Technology Co., Ltd. The additive contains protective groups and catalytic components. The protective groups can selectively adsorb onto the oxide layer to block alkali contact, and the catalytic components can accelerate reactions between exposed polysilicon and alkali. The locking layer 14, due to its thinness and porous surface, is not a complete oxide layer. When performing wet etching using a mixture of alkali and the additive, alkali penetrates the blocking layer 14 and therefore corrodes polysilicon under the blocking layer 14. As the first region S21 is protected by the complete oxide layer 151, the polysilicon thereunder can be protected from being corroded.

### 8. Passivation layer preparation

As illustrated in FIG. 5h, using an ALD process, a first passivation layer 21 and a second passivation layer 22 are respectively prepared on the first surface S1 and the second surface S2 of the silicon substrate. The first passivation layer 21 and the second passivation layer 22 are each an aluminum oxide passivation layer having a thickness ranging from 2 nm to 7 nm, and preferably, from 3 nm to 6 nm.

After the removal of the winding plating and the chemical etching, the tunneling layer and the doped polysilicon layer in the first region S21 can ensure a passivation effect. However, the second region S22 lacks protection of the passivation layer. Therefore, the second passivation layer 22 is required to be prepared on the back surface to ensure a satisfactory interface passivation effect in the second region S22.

Additionally, under a high-temperature sintering condition that guarantees satisfactory front-surface contact, the second passivation layer 22 has a certain effect of blocking the paste on the back surface, allowing the second doped layer 13 and the third doped layer 15 to be further thinned to enhance a short-circuit current density of the cell.

### 9. Anti-reflection layer preparation

As illustrated in FIG. 5i, using the PECVD process, a first anti-reflection layer 31 and a second anti-reflection layer 32 are respectively prepared on the first surface S1 and the second surface S2 of the silicon substrate. Each of the first anti-reflection layer 31 and the second anti-reflection layer 32 may be a layered film formed by one or more of a silicon nitride layer, a silicon oxynitride layer, and a silicon oxide layer, and has a thickness ranging from 60 nm to 130 nm.

### 9. Printing metallic electrode

As illustrated in FIG. 5j, the first electrode 41 and the second electrode 42 are respectively printed on the front surface and the back surface using a screen printing process, followed by sintering and a light injection or an electrical injection, to form ohmic contact.

The first electrode 41 and the second electrode 42 are each a grid line electrode known in the related art and typically includes a main grid line and a fine grid line. It should be noted that since the fine grid line of the second electrode 42 is required to be printed in the first region S21, the first sub-region 101 must have a greater width than the fine grid line 421 of the second electrode 42 for the alignment of the fine grid line.

In the present example, a process flow involves: texturing → boron diffusion → back surface polishing → PE-poly→ laser processing →annealing→ removing winding plating → ALD → PECVD → screen printing. The TOPCon cell can be prepared through the above steps. Thereafter, the cell is tested, sorted, and stored.

### Example 2

The solar cell of Example 2 is substantially the same as that of Example 1 in terms of structure and preparation method. The difference lies in that the first doped layer 11 in Example 1 is prepared under the first surface S1 of the silicon substrate using the boron diffusion process, while the first doped layer 11 in the present example is prepared on the first surface S1 of the silicon substrate using the PECVD process.

Specifically, in the present example, a boron-doped amorphous silicon layer 11' is deposited on the first surface S1 using the PECVD process. Then, the first doped layer 11, i.e., a P-type doped polysilicon layer, is formed through high-temperature oxidation and annealing

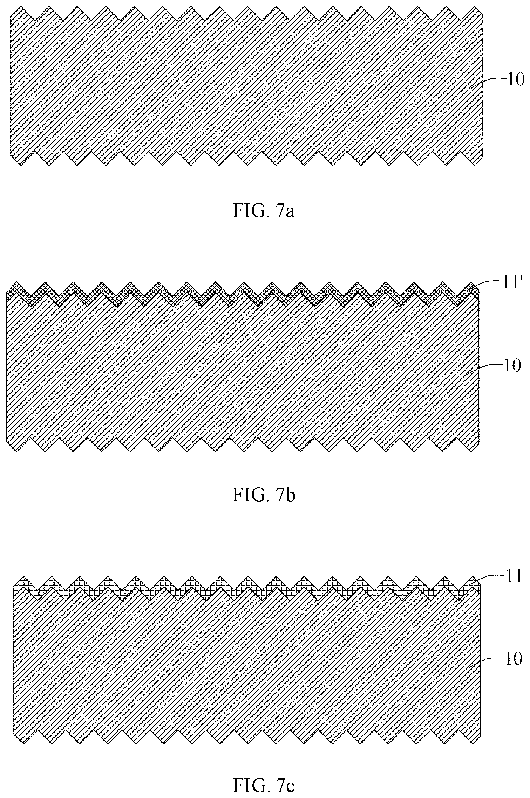

As illustrated in FIG. 7a, the double-sided texturing is performed on the silicon substrate 10. The texturing process is identical to that in Example 1, which is not repeatedly described in detail herein.

As illustrated in FIG. 7b, the boron-doped amorphous silicon layer 11' is deposited on the first surface S1 using the PECVD process. For example, in the PECVD process, N₂O is first introduced to form the silicon oxide layer (not illustrated) on the first surface S1; then SiH₄ and trimethyl boron are introduced to form the boron-doped amorphous silicon layer on the silicon oxide layer; and finally, N₂O is introduced to form a silicon oxynitride mask (not illustrated).

As illustrated in FIG. 7c, the first doped layer 11 is formed through high-temperature oxidation and annealing process. By means of the high-temperature oxidation and annealing process, the P-type doped amorphous silicon layer is converted into the P-type doped polysilicon layer.

The present example differs from Example 1 in that, the P-type doped polysilicon layer is prepared on the surface of the silicon substrate 10 through PECVD process and annealing, during which the thickness of the silicon substrate 10 remains constant. The total thickness of the silicon substrate 10 and the first doped layer 11 after the annealing in FIG. 7c is equal to a total thickness of the silicon substrate 10 and the boron-doped amorphous silicon layer 11' before the annealing in FIG. 7b, and is greater than the thickness of the silicon substrate 10 before the PECVD process in FIG. 7a.

### Example 3

The solar cell of Example 3 is substantially the same as that of Example 1 in terms of structure and preparation method. The difference lies in that, in step 5 of the method in Example 1, the first region S21 is treated using the laser processing to form the oxide layer mask on the surface of the third doped layer 15, whereas a mask in the first region S21 in the present example is prepared by the following process.

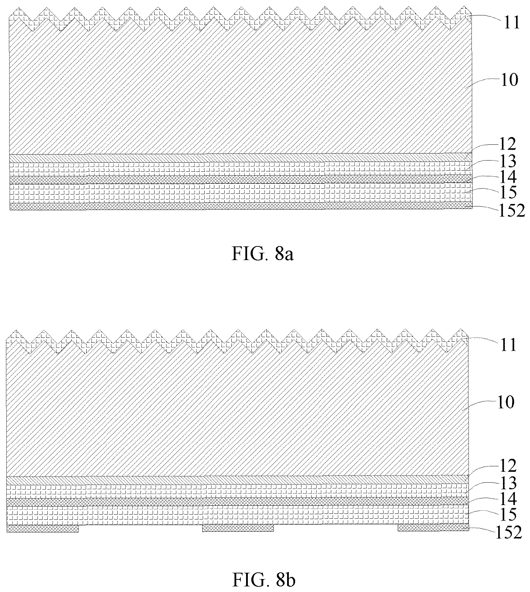

As illustrated in FIG. 8a, in the step of depositing the tunnel passivation structure on the back surface, the oxide layer 152, preferably silicon oxide, is deposited on the surface of the third doped layer 15 by still using the PECVD process.

As illustrated in FIG. 8b, after the annealing process, the mask in the second region S22 is removed by performing a laser etching process.

After the annealing, the structure on the back surface of the silicon substrate is composed of the tunneling layer/the phosphorus-doped polysilicon layer/the blocking layer/the phosphorus-doped polysilicon layer/the silicon oxide layer. The laser etching process mainly acts on the mask (SiO₂). Laser parameters in the laser etching process are controlled based on a material and a thickness of the mask, which are not described in detail herein.

The structure of the solar cell and other preparation processes in the present example are the same as those in Example 1, which are not repeatedly described in detail herein.

From the above technical solutions, that the present disclosure at least provides the following technical effects.

In the solar cell of the present disclosure, only the metallic region of the back surface is laminated with a tunneling passivation contact structure, and a non-metallic region do not have such a structure. In this way, parasitic absorption on the back surface of the cell can be reduced and a current can be increased, without affecting contact performance between the electrode and the doped layer on the back surface, which can improve a cell efficiency and bifaciality and enhance a process window.

The tunneling passivation contact structure in the metallic region of the back surface includes two doped layers and one blocking layer. The blocking layers have a certain capacity of blocking the electrode paste to penetrate through the back surface, which can further reduce a total thickness of the doped layers on the back surface, thereby enhancing an open-circuit voltage of the cell and improving a cell efficiency.

The second passivation layer in the non-metallic region of the back surface can ensure the passivation performance of the back surface of the cell. Additionally, the second passivation layer also has a certain effect of blocking the electrode paste to penetrate through the back surface, allowing the total thickness of the doped layers in the metallic region to be further reduced. In this way, a short-circuit current density of the cell can be increased without affecting performance of metallized contact, thereby improving the cell efficiency and the bifaciality.

It is apparent to those skilled in the art that the present disclosure is not limited to the details of the above exemplary embodiments, and that the present disclosure can be implemented in other specific forms without departing from the spirit or essential features of the present disclosure. Therefore, the examples should be regarded as illustrative and nonlimiting in any point of view. The scope of the present disclosure is limited by the appended claims rather than the above description, and thus all changes falling within the meaning and the scope of equivalency of the claims are intended to be encompassed by the present disclosure. No reference numerals of the accompanying drawings in the claims should be construed as limiting the claims to which they relate.

In addition, it should be understood that, although the specification is described by means of the embodiments, not each embodiment contains only one independent technical solution. The specification is described in this manner only for the sake of clarity. Those skilled in the art should consider the specification as a whole. Also, the technical solutions in different embodiments can be combined appropriately to form other embodiments that can be understood by those skilled in the art.

## Claims

1. A solar cell, comprising:
a silicon substrate comprising a first surface and a second surface arranged opposite to the first surface, wherein the second surface comprises first regions and second regions that are alternately arranged; and
a tunneling passivation contact structure disposed on the second surface, wherein a projection of the tunneling passivation contact structure on the second surface of the silicon substrate is located within the first region, and wherein the tunneling passivation contact structure comprises a tunneling layer in direct contact with the silicon substrate, a second doped layer disposed on the tunneling layer, and a blocking layer and a third doped layer that are sequentially disposed on the second doped layer, the second doped layer, the third doped layer and the silicon substrate containing impurities of same conductive type; and
a second electrode disposed in the second region and in contact with the third doped layer.

2. The solar cell according to claim 1, wherein the second doped layer and the third doped layer satisfy at least one of the following conditions:
a thickness of the third doped layer is greater than or equal to a thickness of the second doped layer;
a total thickness of the second doped layer and the third doped layer ranges from 50 nm to 150 nm or from 60 nm to 100 nm;
a thickness of the second doped layer ranges from 1 nm to 100 nm, and a thickness of the third doped layer ranges from 1 nm to 150 nm; or
the thickness of the second doped layer ranges from 1 nm to 50 nm, and the thickness of the third doped layer ranges from 50 nm to 100 nm.

3. The solar cell according to claim 1, further comprising a second passivation layer, wherein the second passivation layer is in contact with the second surface of the silicon substrate in the second region, and wherein the second passivation layer covers the third doped layer in the first region,
optionally, the second passivation layer is an aluminum oxide passivation layer and has a thickness ranging from 2 nm to 7 nm or from 3 nm to 6 nm.

4. The solar cell according to claim 3, further comprising a second anti-reflection layer disposed on the second passivation layer, wherein the second anti-reflection layer is a layered film formed by one or more of a silicon nitride layer, a silicon oxynitride layer, and a silicon oxide layer, the second anti-reflection layer having a thickness ranging from 60 nm to 130 nm.

5. The solar cell according to claim 1, wherein the solar cell satisfies at least one of the following conditions:
the silicon substrate is an N-type silicon substrate, and each of the second doped layer and the third doped layer is an N-type doped polysilicon layer;
a surface doping concentration of the third doped layer is greater than or equal to a surface doping concentration of the second doped layer;
a surface doping concentration of the second doped layer ranges from 3E20 cm⁻³ to 3E21 cm⁻³ or from 5E20 cm⁻³ to 2E21 cm⁻³;
the surface doping concentration of the third doped layer ranges from 3E20 cm⁻³ to 3E21 cm⁻³ or from 5E20 cm⁻³ to 2E21 cm⁻³;
the tunneling layer is one of a silicon oxide layer and a silicon oxynitride layer, or a combination thereof;
a thickness of the tunneling layer ranges from 0.5 nm to 3 nm or from 1.5 nm to 2.5 nm;
the blocking layer is one of a silicon oxide layer and a silicon carbide layer, or a combination thereof; and
a thickness of the blocking layer ranges from 0.5 nm to 3 nm or from 1.5 nm to 2 nm.

6. The solar cell according to claim 1, further comprising a first doped layer and a first electrode formed on the first surface of the silicon substrate, wherein:
the first doped layer containing impurities of a conductive type opposite to that of the silicon substrate; and
the first electrode is in contact with the first doped layer,
optionally, the first doped layer satisfies at least one of the following conditions:
the first doped layer is a P-type doped layer; and
a surface doping concentration of the first doped layer ranges from 3E18 cm⁻³ to 3E19 cm⁻3

7. The solar cell according to claim 6, further comprising a first passivation layer and a first anti-reflection layer that are disposed on the first doped layer,
optionally, the first passivation layer is an aluminum oxide passivation layer and has a thickness ranging from 2 nm to 7 nm or from 3 nm to 6 nm, and
optionally, the first anti-reflection layer is a layered film formed by one or more of a silicon nitride layer, a silicon oxynitride layer, and a silicon oxide layer and has a thickness ranging from 60 nm to 130 nm.

8. The solar cell according to claim 1, wherein:
a plurality of first regions are arranged in parallel, and a plurality of second regions are arranged in parallel, the plurality of first regions and plurality of second regions being alternately arranged; and
the second electrode comprises a plurality of grid lines arranged in parallel, the plurality of grid lines corresponding to the plurality of first regions in one-to-one correspondence, and a width of each of the plurality of first regions being greater than or equal to a width of each of the plurality of grid lines.

9. The solar cell according to claim 8, wherein:
the width of each of the plurality of first regions ranges from 50 µm to 150 µm; and
the width of each of the plurality of grid lines ranges from 15 µm to 100 µm.

10. A method for preparing a solar cell according to any one of claims 1 to 9, comprising:
providing a silicon substrate comprising a first surface and a second surface arranged opposite to the first surface, wherein the second surface comprises first regions and second regions that are alternately arranged;
preparing a tunneling passivation contact structure on the second surface, wherein the tunneling passivation contact structure comprises a tunneling layer, a second doped layer, a blocking layer, and a third doped layer that are sequentially disposed on each other;
removing the tunneling passivation contact structure in the second region, to retain the tunneling passivation contact structure in the first region; and
preparing a second electrode at the tunneling passivation contact structure in the first region, the second electrode being in contact with the third doped layer.

11. The method according to claim 10, further comprising, prior to said removing the tunneling passivation contact structure in the second region:
treating the third doped layer in the first region using a laser processing, to form an oxide layer on a surface of the third doped layer in the first region,
optionally, the laser processing satisfies at least one of the following conditions:
the laser processing is performed in an oxygen-containing atmosphere, with a volume concentration of oxygen ranging from 20% to 80%;
a laser power during the laser processing ranges from 1 W to 100 W or from 30 W to 60 W;
a laser frequency during the laser processing ranges from 1 kHz to 1,000 kHz or from 300 kHz to 600 kHz;
a laser scanning speed during the laser processing ranges from 10,000 mm/s to 100,000 mm/s or from 30,000 mm/s to 60,000 mm/s; and
the number of times of laser processing operations during the laser processing ranges from 1 to 100 or from 1 to 10.

12. The method according to claim 11, wherein said removing the tunneling passivation contact structure in the second region comprises:
removing, by using the oxide layer as a mask, the second doped layer, the blocking layer, and the third doped layer in the second region using an alkali solution, and removing the tunneling layer in the second region and the oxide layer in the first region using an acid solution.

13. The method according to claim 10, wherein said preparing the tunneling passivation contact structure on the second surface comprises:
sequentially depositing the tunneling layer, a first doped amorphous silicon layer, the blocking layer, and a second doped amorphous silicon layer on the second surface of the silicon substrate; and
performing annealing on the silicon substrate deposited with the tunneling layer, the first doped amorphous silicon layer, the blocking layer, and the second doped amorphous silicon layer at a temperature ranging from 880°C to 980°C to convert doped amorphous silicon layers into doped polysilicon layers.

14. The method according to claim 10, further comprising:
preparing a first doped layer on the first surface, the first doped layer containing impurities of a conductive type opposite to that of the silicon substrate; and
preparing a first electrode on the first surface, the first electrode being in contact with the first doped layer,
optionally, further comprising:
preparing a first passivation layer and a first anti-reflection layer on the first surface of the silicon substrate; and
preparing a second passivation layer and a second anti-reflection layer on the second surface of the silicon substrate.

15. A photovoltaic module, comprising a plurality of solar cells, each of the plurality of solar cells being the solar cell according to any one of claims 1 to 9.
